(19) **Europäisches Patentamt**

**European Patent Office**

**Office européen des brevets**

(11) **EP 1 053 593 B1**

(12) **FASCICULE DE BREVET EUROPEEN**

(45) Date de publication et mention
de la délivrance du brevet:
**08.05.2002 Bulletin 2002/19**

(21) Numéro de dépôt: **99901689.2**

(22) Date de dépôt: **02.02.1999**

(51) Int Cl.⁷: **H03H 9/64**

(86) Numéro de dépôt international:
**PCT/FR99/00214**

(87) Numéro de publication internationale:
**WO 99/40678 (12.08.1999 Gazette 1999/32)**

(54) **FILTRE A RESONATEURS A ONDES ACOUSTIQUES DE SURFACE**

RESONATORFILTER MIT AKUSTISCHEN OBERFLÄCHENWELLEN

FILTER WITH SURFACE ACOUSTIC WAVE RESONATORS

(84) Etats contractants désignés:
**DE FI FR GB IT SE**

(30) Priorité: **06.02.1998 FR 9801419**

(43) Date de publication de la demande:
**22.11.2000 Bulletin 2000/47**

(73) Titulaire: **Thales**
**75008 Paris (FR)**

(72) Inventeurs:
- **SOLAL, Marc, Thomson-CSF PI Dépt.**
**94117 Arcueil Cedex (FR)**
- **DESBOIS, Jean, Thomson-CSF PI Dépt.**
**94117 Arcueil Cedex (FR)**

(56) Documents cités:
**US-A- 5 508 667**

## Description

Le domaine de l'invention est celui des filtres à ondes acoustiques de surface présentant des performances très sélectives en fréquence, soit des largeurs de bande relativement faibles, avec de grandes qualités de rejection. Par ondes de surface, on entend ici non seulement des ondes de Rayleigh mais également tout type d'onde pouvant interagir avec des peignes d'électrodes à la surface d'un cristal ou à l'interface entre un cristal et une ou plusieurs couches d'un matériau quelconque. Les ondes dites pseudo acoustiques de surface, les ondes de surface transverses, ou les ondes de surface de type SSBW peuvent ainsi être considérées comme des ondes de surface et l'invention s'applique à ce type d'onde ainsi qu'à tout autre type d'onde vérifiant les conditions précédentes.

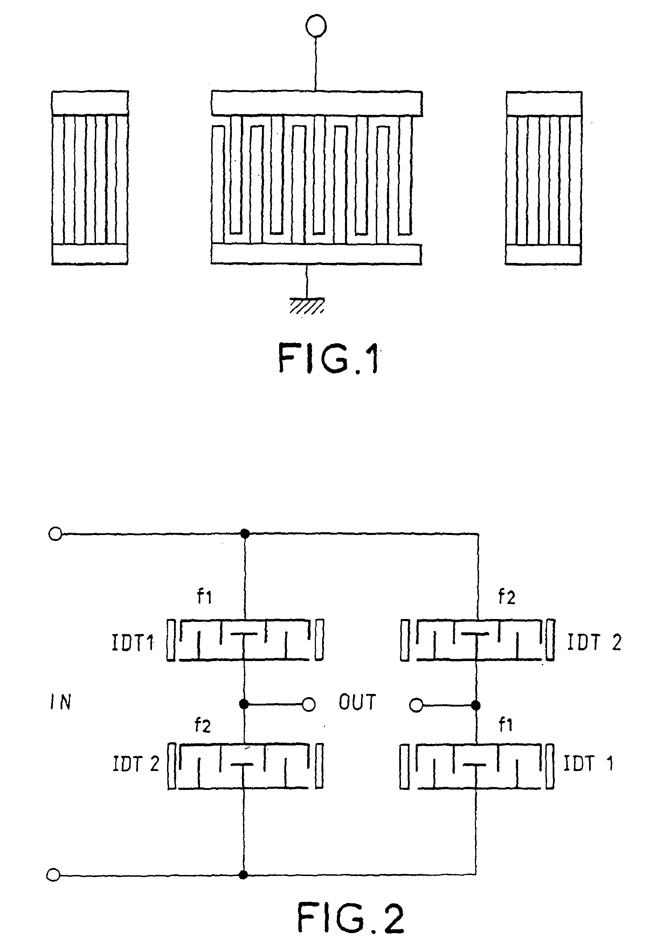

De manière générale, pour obtenir ce type de performances, on utilise des filtres avec des résonateurs constitués classiquement de transducteurs compris dans une cavité formée de deux réseaux périodiques, comme illustré en figure 1. Plus précisément, il s'agit de filtres multipôles obtenus en couplant plusieurs résonateurs. On cherche en effet à coupler le plus grand nombre de résonateurs puisque le nombre de résonateurs. couplés entre eux détermine en général le facteur de forme du filtre, c'est-à-dire le rapport entre la bande de rejection du filtre et sa bande passante. L'augmentation du nombre de résonateurs permet de se rapprocher d'un rapport de forme 1.

A l'heure actuelle, il est connu une configuration de filtre à ondes acoustiques de surface à deux pôles comportant une première paire de résonateurs $IDT_1$ avec une fréquence centrale $f_1$, une seconde paire de résonateurs $IDT_2$ avec une fréquence centrale $f_2$, l'ensemble des deux paires étant monté dans une structure de pont « équivalent électrique » comme illustré en figure 2. Ce type de configuration est décrit dans le brevet US 5 508 667.

L'intérêt de cette structure réside dans le fait que le produit des capacités statiques de la première paire est le même que le produit des capacités statiques de la seconde paire. Cet équilibrage permet d'assurer la rejection du filtre loin de sa fréquence centrale. En effet, loin de cette fréquence, les résonateurs sont électriquement équivalents à leurs capacités statiques et l'équilibrage permet qu'aucun signal ne passe.

Pour augmenter encore les performances des filtres à résonateurs il a été envisagé de cascader en série plusieurs structures à ponts « équivalent électrique ». Le plus souvent, on cascade des ponts identiques entre eux. L'inconvénient d'une telle structure réside dans le fait que cette cascade nécessite pour être efficace d'ajouter un élément électrique supplémentaire (inductance ou capacité). D'autre part, l'utilisation de plusieurs « ponts » cascadés représente un obstacle au niveau de l'implantation à l'intérieur du boîtier du filtre.

C'est pourquoi, l'invention propose une structure de filtre permettant de s'affranchir de la nécessité de l'inductance de couplage dans laquelle une unique structure de pont équivalent peut comprendre un grand nombre de pôles, par une mise en parallèle de différents résonateurs dans chaque bras du pont.

Plus précisément, l'invention a pour objet un filtre à ondes acoustiques de surface à N pôles, N étant un nombre pair supérieur ou égal à 3, et comportant un ensemble de résonateurs, caractérisé en ce que :

-    les résonateurs sont couplés électriquement pour former un pont électrique à 4 bras ;
-    2 bras comportant deux sous-ensembles identiques $E_1$ et $E_3$ de $N_1$ résonateurs chacun montés en parallèle ;
-    2 bras comportant deux sous-ensembles identiques $E_2$ et $E_4$ de $N_2$ résonateurs chacun montés en parallèle ;
-    avec $N_1 + N_2 = N$ ;
-    le produit de la capacité statique totale du sous-ensemble $E_1$ par la capacité statique totale du sous-ensemble $E_3$ étant sensiblement équivalent au produit de la capacité statique totale du sous-ensemble $E_2$ par la capacité statique totale du sous-ensemble $E_4$, de manière à équilibrer le pont électrique.

Selon une première variante de . l'invention si N est pair $N_1 = N_2 = N/2$.

Selon une seconde variante de l'invention si N est impair $N_1 = (N-1)/2$ et $N_2 = (N + 1) / 2$.

Selon la configuration de filtre proposée dans l'invention, la mise en parallèle des résonateurs nécessite des fils de connexion ou des pistes sur le substrat pour réaliser les ponts. Pour s'affranchir de cet obstacle. un mode préférentiel de l'invention consiste à ne pas faire physiquement la mise en parallèle des résonateurs mais plutôt à utiliser dans les différents bras du pont, des dispositifs à onde de surface se comportant comme plusieurs résonateurs branchés en parallèle.

C'est pourquoi, le filtre à ondes acoustiques de surface peut avantageusement comprendre dans au moins un des bras du pont électrique, un unique dispositif à ondes de surface ayant une admittance équivalente à la mise en parallèle d'un sous-ensemble de résonateurs.

Notamment le filtre selon l'invention peut être caractérisé en ce qu'au moins un bras comporte une structure équivalente à plusieurs résonateurs montés en parallèle, ladite structure comportant deux réseaux d'électrodes interdigitées constitutifs de la partie transduction des résonateurs, lesdits réseaux étant connectés à deux bus de polarités différentes et comprenant m voies acoustiques insérées entre les deux bus, la $i^{ème}$ voie acoustique possédant un pas $p_i$ d'électrodes, sur une longueur d'électrodes $w_i$ et $1 \leq i \leq m$.

Selon une variante de l'invention, la $i^{ème}$ voie acoustique peut comporter de chaque côté de la partie transduction deux réseaux réflecteurs.

Selon une variante de l'invention, le filtre à ondes acoustiques de surface peut comprendre dans au moins un des bras du pont électrique, une structure équivalente à au moins deux résonateurs montés en parallèle, ladite structure comportant deux réseaux d'électrodes interdigitées, lesdits réseaux étant connectés à un premier bus et à un second bus de polarités différentes, de manière à définir un transducteur présentant un axe central Z parallèle aux électrodes, lesdits réseaux comprenant une partie de leurs électrodes positionnées symétriquement par rapport à l'axe central, le transducteur comprenant également des électrodes positionnées symétriquement par rapport à l'axe central et connectées à des bus de polarités différentes, de manière à exciter des modes longitudinaux symétriques et des modes longitudinaux antisymétriques. Les réseaux d'électrodes peuvent ou non être insérés entre des réseaux réflecteurs

Selon une autre variante de l'invention, le filtre à ondes acoustiques de surface comprend dans au moins un des bras du pont électrique, un résonateur de type DART avec des cellules de transduction intercalées entre des cellules de réflexion.

Avantageusement, le résonateur de type DART peut comprendre des cavités résonantes.

Lorsque le nombre de pôles est pair, la distance entre le centre de transduction d'une cellule de transduction et le centre de réflexion de la cellule de réflexion adjacente à ladite cellule de transduction peut de manière préférentielle être de l'ordre de $(3 \pm d) \lambda/8 + k\lambda/2$, avec $\lambda$ longueur d'onde correspondant à la fréquence centrale du filtre, d inférieur à 1 et k entier.

Enfin, selon une autre variante, le filtre à ondes acoustiques de surface est caractérisé en ce qu'il comprend la mise en série de plusieurs ensembles de résonateurs, dont au moins un ensemble de résonateurs correspond à ceux de l'invention.

L'invention sera mieux comprise et d'autres avantages apparaîtront à la lecture de la description qui va suivre, donnée à titre non limitatif et grâce aux figures annexées parmi lesquelles :

- la figure 1 schématise un résonateur avec un transducteur inséré entre des réseaux réflecteurs ;
- la figure 2 illustre une configuration de filtre selon l'art connu, monté dans une structure de pont ;
- la figure 3 schématise une configuration générale de filtre à ondes acoustiques de surface selon l'invention ;
- la figure 4 illustre une implantation de filtre à ondes acoustiques de surface de l'art antérieur, à deux pôles ;
- la figure 5a schématise une implantation de filtre à ondes acoustiques de surface comprenant deux résonateurs montés en parallèle ;
- la figure 5b illustre un premier exemple d'implantation de résonateur équivalent à deux résonateurs montés en parallèle représentés en figure 5a ;
- la figure 6 illustre un deuxième exemple d'implantation de résonateur équivalent à deux résonateurs montés en parallèle, utilisant trois voies acoustiques ;
- la figure 7 illustre un troisième exemple d'implantation de résonateur équivalent à deux résonateurs montés en parallèle, utilisant deux voies acoustiques, mais décalés d'un pas $p_i$ ;
- la figure 8 illustre un quatrième exemple d'implantation de résonateur équivalent à deux résonateurs montés en parallèle, utilisant l'excitation de modes symétriques et de modes antisymétriques longitudinalement ;
- la figure 9 illustre l'admittance d'un exemple de transducteur de type DART, dans lequel le centre d'une cellule de transduction est séparé du centre d'une cellule de réflexion adjacente, d'une distance $3\lambda/8$ ;
- la figure 10 illustre l'évolution de la conductance du même transducteur de type DART, dans lequel le centre d'une cellule de transduction est séparé du centre d'une cellule de réflexion adjacente, d'une distance variant de $(3 - 0,4) \lambda/8$ à $(3 + 0,4) \lambda/8$ ;
- la figure 11 illustre l'évolution de la susceptance du même transducteur de type DART, dans lequel le centre d'une cellule de transduction est séparé du centre d'une cellule de réflexion adjacente, d'une distance variant de $(3 - 0,4) \lambda/8$ à $(3+0,4) \lambda/8$ ;
- la figure 12 illustre la fonction de transfert pour un exemple de filtre selon l'invention, à 4 pôles, utilisant des DART ;
- la figure 13 illustre l'admittance d'un bras de pont électrique, comprenant un DART à deux modes utilisés dans un exemple de filtre selon l'invention, à 3 pôles ;
- la figure 14 illustre l'admittance du deuxième bras de pont électrique, comprenant un DART non pondéré, dans un exemple de filtre selon l'invention à 3 pôles ;
- la figure 15 illustre la fonction de transfert du même exemple de filtre selon l'invention, à 3 pôles, comprenant un résonateur à un mode dans un bras et un résonateur à deux modes dans l'autre bras ;
- la figure 16 illustre les conductances de deux résonateurs utilisés dans un exemple de filtre à 87 MHz selon l'invention utilisant des résonateurs du type illustré en figure 6 ;
- la figure 17 illustre les susceptances de deux résonateurs utilisés dans un exemple de filtre à 87 MHz selon l'invention utilisant des résonateurs du type illustré en figure 6 ;
- la figure 18 illustre l'implantation du filtre dont les caractéristiques sont données en figures 15, 16 et 17 ;

- la figure 19 illustre la fonction de transfert du filtre à 87 MHz réalisé selon l'invention.

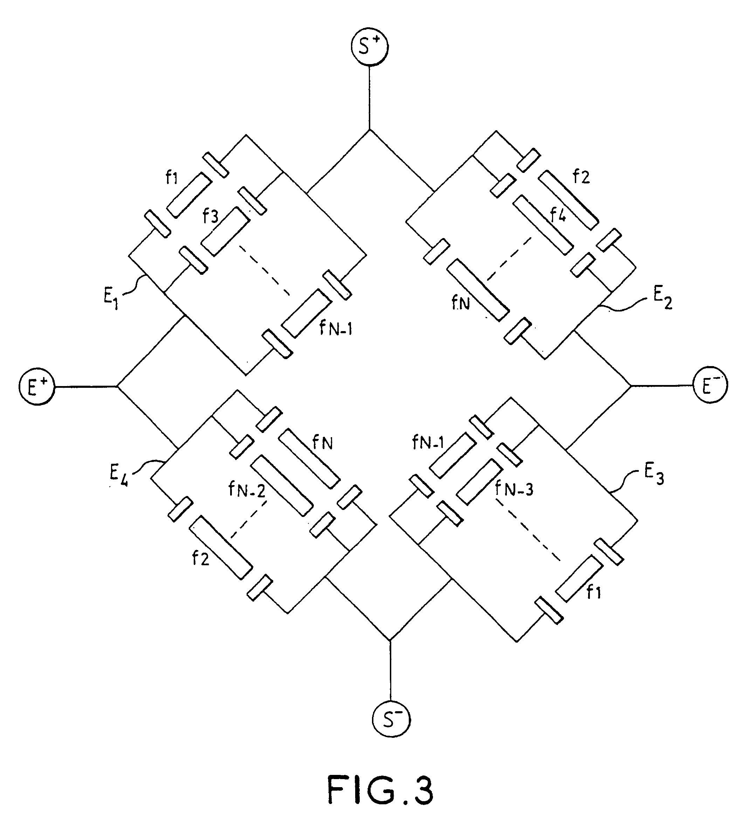

La configuration générale d'un filtre à ondes acoustiques de surface selon l'invention est schématisée en figure 3. Elle comporte une structure en forme de pont équivalent composée de quatre bras, chaque bras comprenant un ensemble de résonateurs montés en parallèle et relié à une entrée (E+, E-) et à une sortie (S+, S-). Les fréquences centrales des résonateurs $f_1$, $f_2$ ... $f_N$ correspondant aux pôles du filtre, ainsi que les « couplages » des différents résonateurs sont choisis pour obtenir la fonction de filtrage désirée.

Pour bien comprendre le fonctionnement, il est nécessaire de s'intéresser de plus près au fonctionnement d'un résonateur. En général, près de la fréquence de résonance on peut considérer que le schéma équivalent d'un résonateur est donné par une capacité statique en parallèle à un circuit résonnant série à la fréquence $f_s$.

L'admittance du résonateur est donc (si l'on néglige la résistance Rs) où f est la fréquence et $\omega$ la pulsation ($\omega = 2\eta f$)

$$Y(f) = j\omega Cp + \cfrac{1}{Rs + jLs\omega - \cfrac{j}{Cs\omega}} \cong j\omega Cp - \frac{jCs\omega}{LsCs\omega^2 - 1}$$

$$Y(f) \cong j\omega Cp - \frac{j2\pi Csf}{4\pi^2 LsCs(f^2 - fs^2)} = j\omega Cp - j\frac{f}{2\pi Ls(f^2 - fs^2)} = j\omega Cp - j\frac{2\pi Csfs^2 f}{(f^2 - fs^2)}$$

On peut donc exprimer l'admittance d'un résonateur sous la forme de la somme d'un terme capacitif lié à la capacité parallèle Cp et d'un terme résonnant proportionnel à un coefficient a :

$$Y(f) \cong j\omega Cp - j\frac{af}{(f^2 - fs^2)}$$

$$a = \frac{1}{2\pi Ls} = 2\pi Csfs^2$$

Le coefficient a (proportionnel à la capacité série du résonateur) détermine le « couplage » du mode de résonance considéré à l'accès électrique. Il sera dénommé par la suite couplage du mode.

Un résonateur idéal sera donc caractérisé par la partie résonante de son admittance qui est de la forme :

$$-aj\frac{f}{f^2 - f_s^2}$$

et qui présente donc un pôle à la fréquence $\pm f_s$. En pratique, du fait des pertes non nulles dans les résonateurs qui sont à peu près équivalents à une résistance série sur la partie résonante, le terme résonant de l'admittance s'écrit :

$$\frac{C_s\omega}{R_sC_s\omega + jL_sC_s\left[\omega^2 - \omega_s^2\right]}$$

Le pôle à la fréquence $f = f_s$ (ou $\omega = \omega_s$) n'est plus un vrai pôle puisqu'il est amorti. Autrement dit, les pertes transforment le pôle en $f = f_s$ en un pôle pour une fréquence complexe de partie réelle proche de $f_s$ et dont la partie imaginaire est d'autant plus forte que les pertes sont grandes. Un résonateur est donc caractérisé par une admittance comportant une résonance amortie ou non et donc présentant un pôle sur une fréquence proche de l'axe réel.

Dans cette configuration, chacun des bras comporte deux résonateurs montés en parallèle.

Nous allons décrire l'invention en détail dans le cas d'un filtre à ondes acoustiques de surface à 4 pôles.

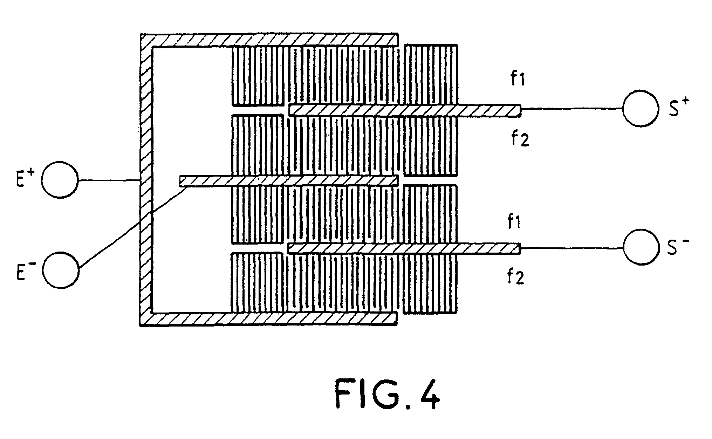

Selon l'art antérieur connu, lorsque l'on cherche à implanter une structure de pont électrique à quatre bras, chaque bras comportant un résonateur, il est possible de concevoir une structure symétrique nécessaire à l'équilibrage du pont et donc aux qualités de rejection du filtre, avec une implantation du type de celle schématisée en figure 4.

Cette implantation présente l'avantage d'être symétrique même en ce qui concerne les capacités parasites par rapport au fond du boîtier. Les surfaces des réseaux réflecteurs $R_i$ sont les mêmes pour les deux ports + et -. D'autre part, la masse n'est pas connectée sur les filtres, puisque tous les réseaux sont branchés à un des ports d'entrée/sortie, ce qui permet de s'affranchir mieux des déséquilibres éventuels des circuits électriques de source et de charge.

Cependant, la symétrie que l'on peut obtenir avec l'implantation décrite ci-dessus est plus difficile à obtenir lorsque l'on augmente le nombre de pôles.

C'est pourquoi, l'invention propose de remplacer la mise en parallèle de plusieurs résonateurs par la réalisation de résonateurs équivalents à cette mise en parallèle et n'utilisant que deux bus de connexion et non plus quatre dans le cas de la mise en parallèle de deux résonateurs (deux entrées, deux sorties).

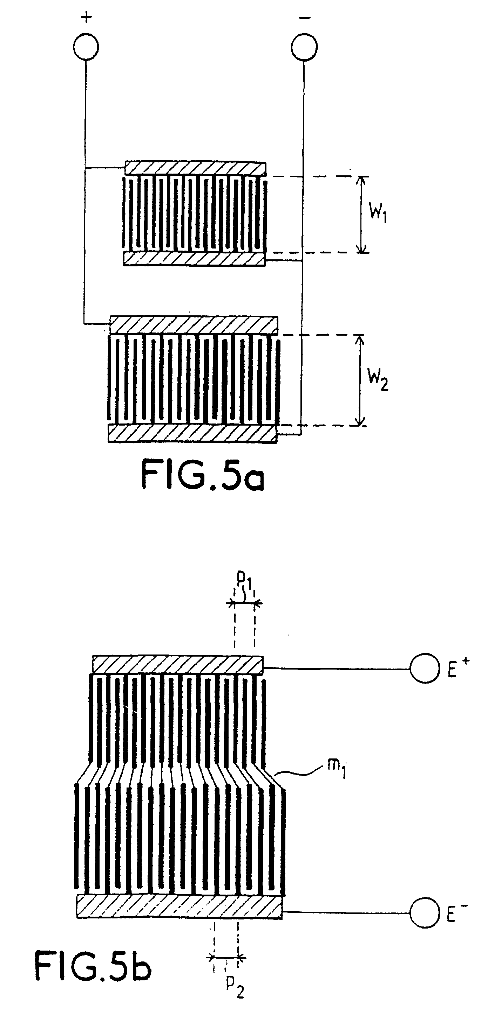

Il est notamment possible de réaliser un résonateur équivalent à deux résonateurs montés en parallèle, en séparant l'ouverture acoustique en deux voies et en interconnectant les électrodes de deux voies de manière à avoir sur chacune des deux voies la séquence correspondant à un des deux transducteurs. A titre d'exemple, la figure 5a illustre une implantation possible pour un montage de deux résonateurs montés en parallèle

La figure 5b illustre une implantation équivalente dans laquelle la première voie acoustique supérieure est réalisée à l'aide d'électrodes interdigitées au pas $p_1$, la seconde voie acoustique inférieure est réalisée à l'aide d'électrodes interdigitées au pas $p_2$. Les deux voies sont connectées électriquement par des métallisations $m_1$, représentées symboliquement sur les figures.

Les pas $p_1$ et $p_2$ régissent les fréquences de résonance du résonateur équivalent aux deux résonateurs montés en parallèle. Les dimensions $w_1$ et $w_2$ conditionnent -le couplage de ces résonateurs de manière à obtenir les caractéristiques du filtre que l'on cherche à fabriquer. Les figures 5a et 5b ne représentent que la partie transductrice des résonateurs. Suivant l'art connu, les résonateurs comprennent en général deux réseaux réflecteurs encadrant un transducteur. Les réseaux réflecteurs sont omis sur la figure, mais peuvent être rajoutés sur chacune des voies. Les réseaux de chacune des voies peuvent être connectés entre eux ou pas. De façon préférentielle, on choisira pour les réseaux réflecteurs des différentes voies des périodes proportionnelles aux périodes des transducteurs. En d'autres termes, si $p_i$ et $p_j$ sont les périodes des deux transducteurs et $P_{Ri}$ et $P'R_j$ les périodes des réseaux, on choisira :

$$\frac{P_i}{P_j} = \frac{PR_i}{PR_j}$$

De même, si $\Delta$ et $\Delta'$ sont les distances entre les réseaux réflecteurs et les transducteurs on choisira préférentiellement :

$$\frac{\Delta i}{\Delta j} = \frac{Pi}{Pj}.$$

De cette manière, les deux voies seront homothétiques l'une de l'autre.

Enfin, pour les filtres comportant plus que 4 pôles, on est amené à mettre plus que deux résonateurs en parallèle. On peut de la même manière que précédemment, utiliser plusieurs voies acoustiques et relier les métallisations des différentes voies entre elles pour réaliser la mise en parallèle.

Néanmoins, dans ce type de configuration, lorsque les deux voies acoustiques de dimensions $w_1$ et $w_2$ sont trop proches, il apparaît des phénomènes de diaphonie acoustiques parasites entre les voies.

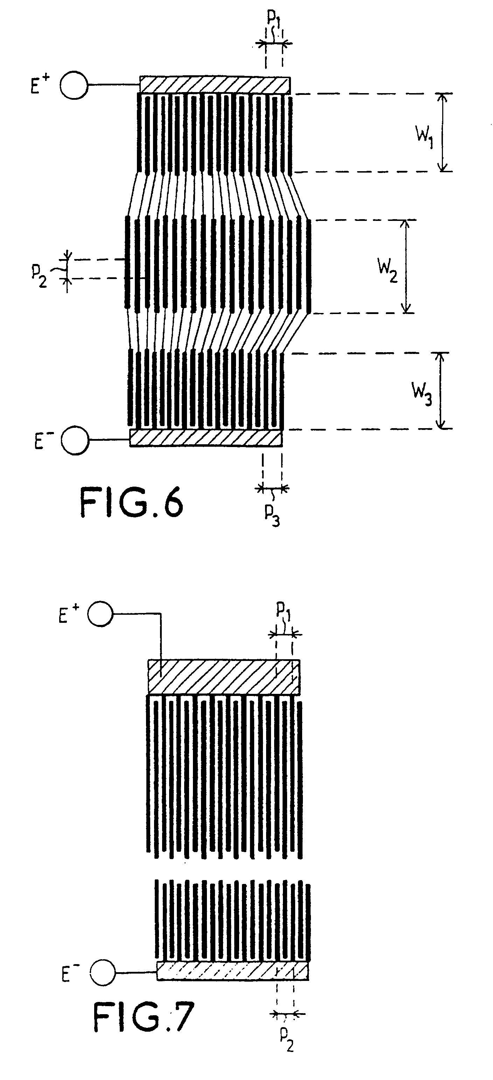

C'est pourquoi, pour éliminer ce type de diaphonie, l'invention propose également une autre structure illustrée en figure 6. Pour cela, la voie centrale qui génère une excitation symétrique par rapport à l'axe horizontal et n'est donc couplée seulement qu'à des ondes de formes symétriques transversalement est insérée entre deux voies supérieure et inférieure correspondant globalement à l'une des voies acoustiques représentée en figure 5b. Les voies acoustiques supérieure et inférieure présentent les mêmes caractéristiques de dimension d'électrodes $w_1 = w_3$ et de pas d'électrodes $p_1 = p_3$. Ces deux voies génèrent à elles deux une excitation antisymétrique par rapport à l'axe horizontal puisque les électrodes en regard pour les deux voies sont reliées à des potentiels opposés. Ces deux voies ne sont donc couplées qu'à des ondes de formes antisymétriques transversalement et il ne peut donc exister aucune diaphonie entre la voie centrale et les voies extérieures. Autrement dit, du fait de la connexion des électrodes en regard des voies extrêmes au bus opposé, la diaphonie entre la voie centrale et la voie haute s'additionne en opposition de phase, et donc s'annule avec la diaphonie entre la voie centrale et la voie basse. Pour obtenir la compensation des phénomènes de couplage, les électrodes connectées au bus E+ sont mises en regard des électrodes connectées au bus E- sur les voies extrêmes.

Les deux fréquences de résonance recherchées, pour reconstituer deux résonateurs montés en parallèle peuvent aussi être obtenues grâce à l'écart de vitesse des modes transversaux symétriques et antisymétriques.

Dans ce cas, il est également possible de réaliser une structure dans laquelle les pas $p_1$ et $p_2$ sont égaux. Dans ce cas particulier, il devient même possible de réaliser une structure à deux voies acoustiques comme illustré en figure 7. En décalant d'une distance $p_1$ les électrodes des deux voies, on parvient à compenser de même qu'explicité ci-dessus, les phénomènes de couplage parasite, puisque l'on parvient à mettre en regard des électrodes connectées au bus E+ avec des électrodes connectées au bus E-. Dans cette configuration, la voie centrale devient alignée avec une des voies extrêmes.

Selon une autre variante de l'invention, il est possible de réaliser une structure équivalente à deux résonateurs montés en parallèle, en paramétrant le nombre de modes longitudinaux créés dans le résonateur.

En effet, de manière générale, un résonateur est un transducteur placé entre deux réseaux réflecteurs. Suivant la période du réseau et celle du transducteur, et suivant l'écartement entre réseaux et transducteur, on est en présence de plusieurs modes longitudinaux. Le couplage d'un mode dépend de l'intégrale de recouvrement de la pondération du transducteur sur l'amplitude du mode dans la cavité. De manière générale, on est en présence de modes symétriques et antisymétriques. Il est possible de pondérer le transducteur, de manière à obtenir les couplages voulus avec les modes symétriques et antisymétriques.

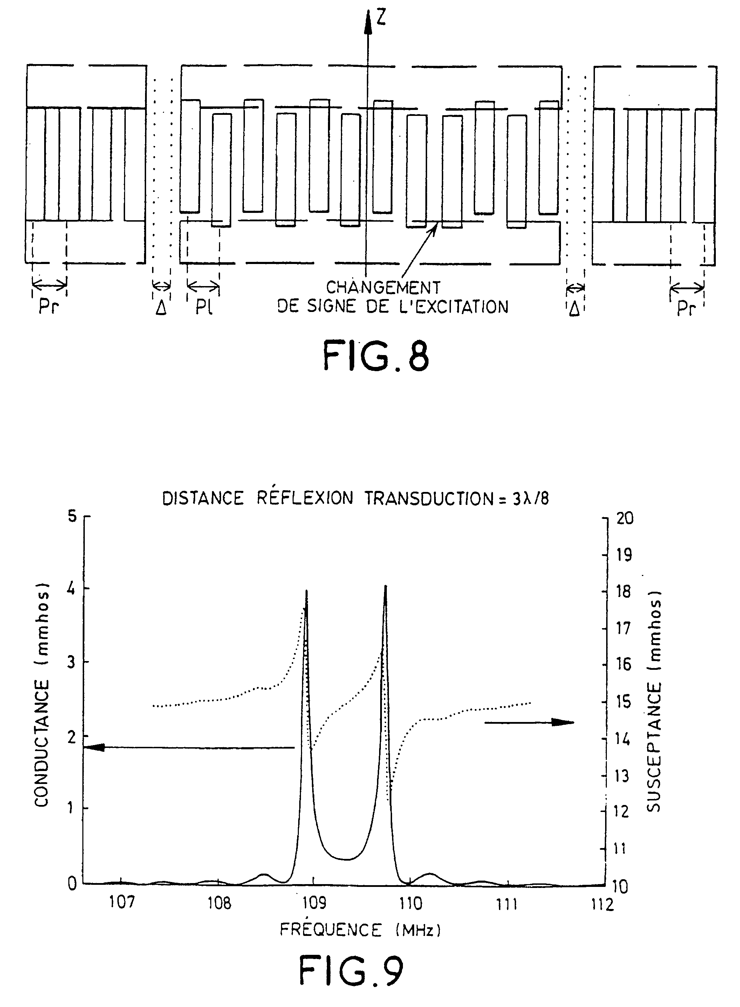

La figure 8 illustre un exemple de résonateur dans lequel il est possible d'exciter à la fois les modes longitudinaux symétriques et les modes longitudinaux antisymétriques.

$P_r$ représente le pas des éléments constitutifs des réseaux 1 et 2. $P_t$ représente le pas des électrodes du transducteur. $\Delta$ représente l'écartement entre le transducteur et un réseau. Le transducteur présente une dissymétrie par rapport à l'axe Z centré au niveau du transducteur.

Suivant les périodes $P_r$ et $P_t$, la distance $\Delta$ et le nombre de périodes du transducteur, la cavité de résonance va avoir plusieurs fréquences de résonance correspondant à différentes répartitions longitudinales de l'énergie dans la cavité. En choisissant de manière appropriée l'excitation, c'est-à-dire la séquence d'électrodes du transducteur, on peut exciter les modes longitudinaux symétriques et les modes longitudinaux antisymétriques. La pondération du transducteur peut être décomposée en deux parties. La partie symétrique (par rapport à l'axe z) de la pondération excitera les modes longitudinaux symétriques alors que la partie antisymétrique (par rapport à l'axe z) excitera les modes longitudinaux antisymétriques. L'intégrale de recouvrement de la partie symétrique (ou antisymétrique) de la pondération sur l'amplitude des modes symétriques (antisymétriques) sera reliée au couplage des modes symétriques (antisymétriques).

Le transducteur représenté en figure 8, n'est ni entièrement symétrique, ni entièrement antisymétrique et permet l'excitation à la fois de modes symétriques et de modes antisymétriques de manière à reconstituer le couplage entre modes, et ainsi l'équivalence avec deux résonateurs montés en parallèle.

Selon une autre variante de l'invention, le filtre à ondes acoustiques de surface, comprend des transducteurs de type DART

Ce type de transducteur, décrit dans la demande de brevet publiée 2 702 899, est réalisé en intercalant dans un transducteur des cellules dites de transduction et des cellules dites de réflexion et en positionnant les cellules entre elles de manière à avoir remis en phase des ondes émises avec les ondes réfléchies dans la direction utile et avoir opposition de phase dans l'autre direction. Pour les substrats habituels, la distance entre centre de transduction et centre de réflexion doit être de $3\lambda/8$ pour que les phases soient correctes. Plus généralement, un DART peut être considéré comme un transducteur dans lequel sont distribuées des électrodes conçues pour qu'existent à l'intérieur du transducteur une fonction de transduction, et une fonction de réflexion et tel que le transducteur ait une direction privilégiée. Il a été montré dans la demande de brevet publiée 2 702 899 qu'il était avantageux de réaliser des cavités résonantes à l'intérieur du DART, une cavité résonante étant réalisée en changeant le signe de la fonction de réflexion.

Il est connu que dans la cas d'un DART non pondéré, c'est-à-dire comportant des fonctions de réflexion et de transduction constantes et suffisamment long pour que son coefficient de réflexion global soit proche de 1, deux modes existent aux fréquences de début et de fin de la bande d'arrêt des réflecteurs. Dans le cas où l'écart de phase entre réflexion et transduction correspond à une remise en phase des ondes émises et réfléchies dans la direction utile, c'est-à-dire en général dans le cas où la distance entre centre de transduction et centre de réflexion est de $3\lambda/8$, les deux modes sont excités de manière identique et la conductance du transducteur est symétrique en fréquence. Par exemple, la figure 9 montre l'admittance d'un transducteur DART de longueur $200\lambda$ à 109.3 MHz. L'épaisseur de métallisation choisie est de 0,7 $\mu$m et un réflecteur de largeur $3\lambda/8$ est utilisé par longueur d'onde. Le transducteur est « idéal » c'est-à-dire que la distance centre de transduction/centre de réflexion est de $3\lambda/8$.

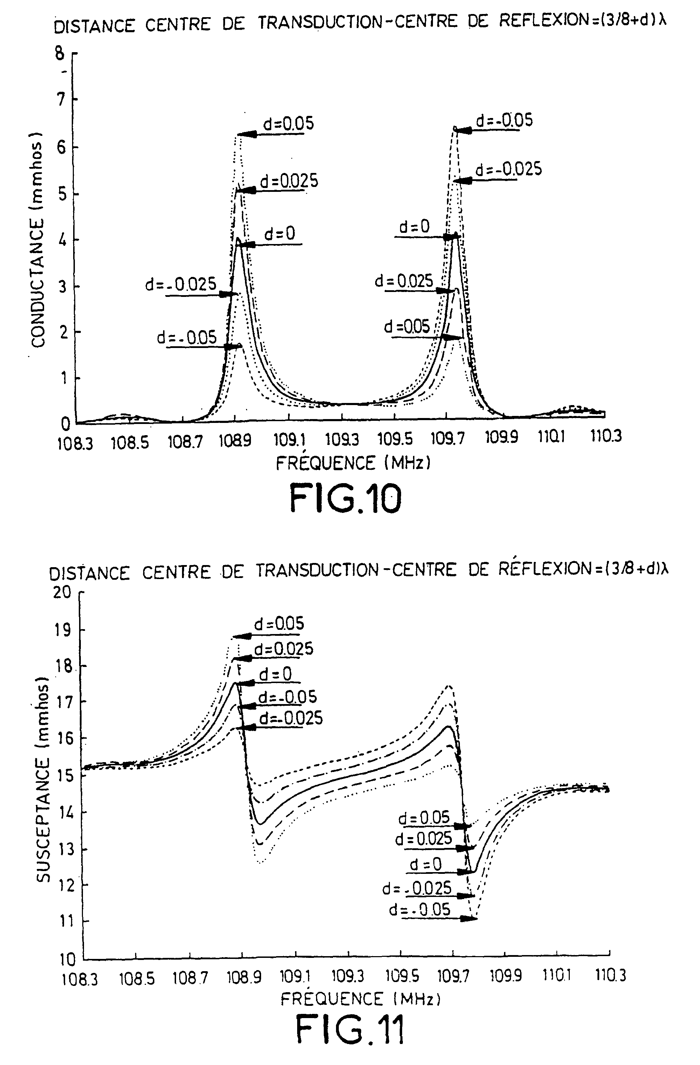

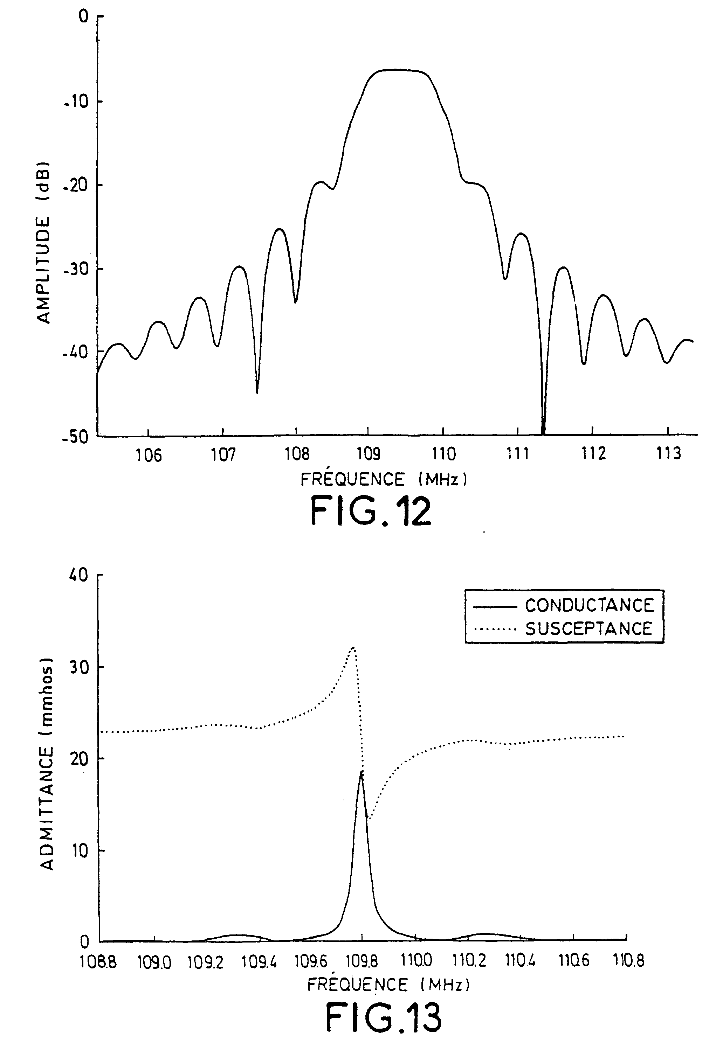

Les figures 10 et 11 montrent l'évolution des conductances et susceptances lorsque la distance : centre de transduction/centre de réflexion varie de $3\lambda/8-0.05\lambda$ à $3\lambda/8+0.05\lambda$. On constate qu'on est toujours en présence des deux mêmes modes mais que leur importance relative varie suivant la distance. D'autre part, lorsque l'on change le signe du décalage, on obtient la même conductance à une symétrie près. Dans le cas d'un filtre à 4 pôles, il est en général intéressant sur un bras du pont électrique d'utiliser des modes tels que leurs couplages soient environ dans un rapport 2. A titre d'exemple, le filtre selon l'invention peut comprendre dans un de ses bras un DART utilisant un décalage de -0.025 $\lambda$ et sur l'autre bras un DART utilisant un décalage de +0.025 $\lambda$. De manière à avoir quatre fréquences de résonance distinctes, on a décalé en fréquence d'environ 250 kHz vers le bas le transducteur utilisant un décalage de -0.025λ. La figure 12 montre la fonction de transfert obtenue pour le filtre accordé électriquement.

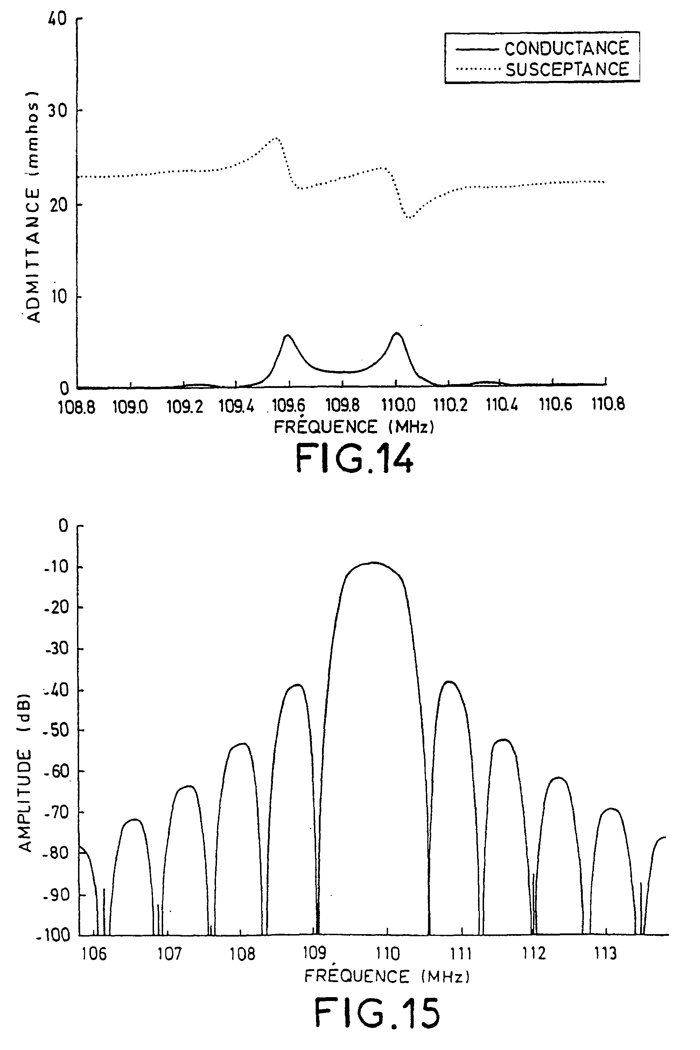

Selon un autre exemple utilisant des DART, un filtre 3 pôles peut être obtenu en utilisant un résonateur à un mode dans un des bras et un résonateurs à deux modes dans l'autre bras. Le résonateurs à deux modes utilisé dans l'exemple est un DART non pondéré avec une distance réflexion transduction de 3λ/8. Le DART a 400 longueurs d'ondes de long. L'épaisseur de métallisation choisie est de 0.35 μm et un réflecteur de largeur 3λ/8 est utilisé par longueur d'onde. La fréquence centrale est de 109.8 MHz. La figure 13 montre l'admittance du DART avec ses deux modes à l'entrée et à la sortie de la bande d'arrêt. Pour l'autre bras du pont électrique, on a choisi d'utiliser un DART de même longueur (et donc de même capacité statique) et résonant à la fréquence centrale. La figure 14 montre l'admittance du DART non pondéré, inclus dans l'autre bras du pont électrique. Ceci a été obtenu en insérant un changement de signe de la fonction de réflexion au centre du transducteur. On a alors un mode résonance unique.

La fonction de transfert obtenue pour le filtre à 3 pôles est donnée figure 15

### Exemple de filtre à 87 MHz sur quartz

Il s'agit d'un filtre à bande passante d'environ 300 kHz dans un boîtier très petit (7 mm x 5 mm) avec un nombre de pôles N égal 4

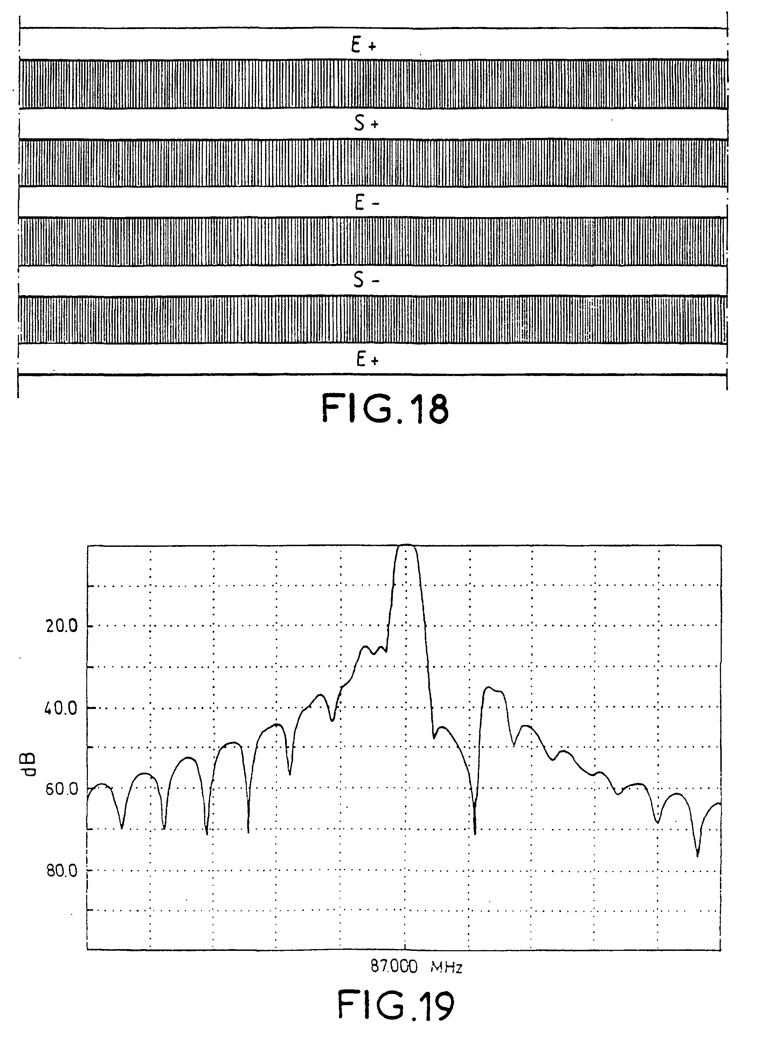

Pour atteindre ce faible encombrement au niveau du boîtier, les résonateurs utilisés ne comportent pas de réseaux réflecteurs et se réduisent donc à de simples transducteurs à deux électrodes par longueurs d'onde. L'implantation est du type de celle illustrée en figure 18. Les longueurs des transducteurs sont de 264 périodes (soit une longueur de 4,75 mm environ). En négligeant les pertes, les admittances des branches sont données à peu près par :

$$Ys(f) = j\left(\frac{a_1 f}{f^2 - f_1^2} + \frac{a_3 f}{f^2 - f_3^2}\right) + jCw$$

$$Ya(f) = j\left(\frac{a_2 f}{f^2 - f_1^2} + \frac{a_4 f}{f^2 - f_4^2}\right) + jCw$$

en choisissant :

$$f_2 - f_1 = 250 \text{ kHz}$$

$$f_3 - f_2 \sim 60 \text{ kHz}$$

et $a_2 = a_1$, $a_3 = a_4 = a_1/2$

$$f_1 - f_4 \sim 60 \text{ kHz}$$

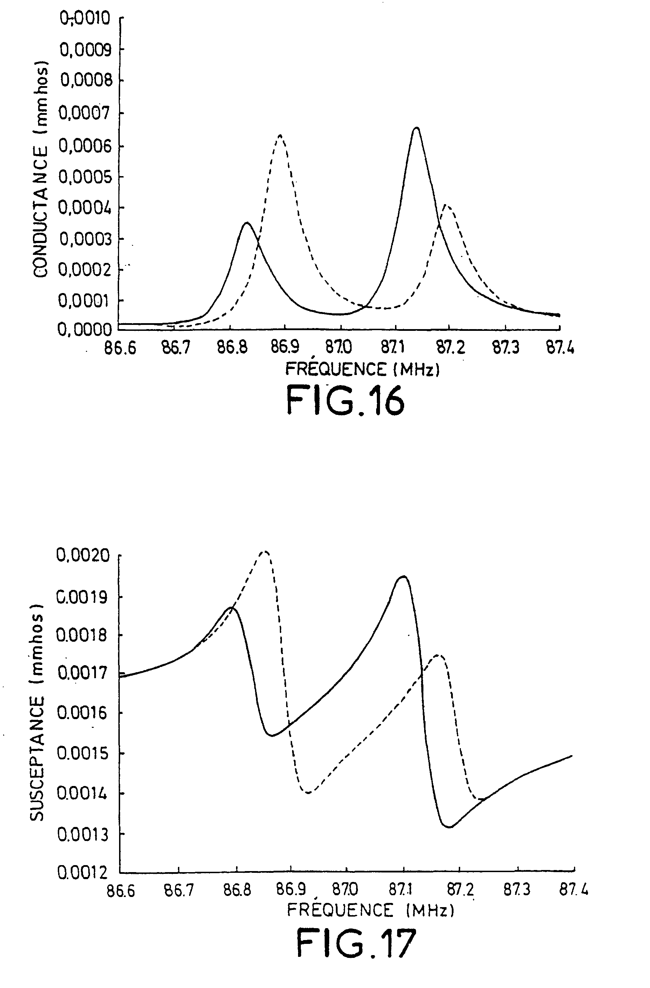

On obtient les caractéristiques de conductances et de susceptances, en fonction de la fréquence respectivement illustrées en figures 16 et 17.

Pour réaliser les admittances voulues des résonateurs, on choisit une ouverture et une épaisseur de métallisation permettant d'obtenir un écart de 310 kHz entre les fréquences de résonance du premier mode transverse symétrique et du premier mode transverse antisymétrique, soit une épaisseur de métallisation de 0,8 μm et une ouverture de transducteur d'environ 300 μm.

La structure de la figure 7 a été choisie pour les résonateurs.

Ainsi, pour les deux résonateurs, on a les caractéristiques suivantes :

1er résonateur (équivalent à deux résonateurs montés en parallèle)

$$w'_1 = 210 \ \mu m$$

$$w'_2 = 90 \ \mu m$$

2ème résonateur (équivalent à deux résonateurs montés en parallèle)

$$w'_1 = 232,5 \ \mu m$$

$$w'_2 = 67,5 \ \mu m$$

Les périodes de ces deux résonateurs sont déterminées de manière à caler correctement les fréquences entre elles à savoir approximativement :

pour le premier résonateur, une période de 17,95 $\mu m$
pour le second résonateur, une période de 17,94 $\mu m$

La figure 18 illustre l'implantation représentative du pont électrique réalisé avec dans deux bras le premier résonateur et dans deux autres bras le second résonateur.
Pour des raisons d'encombrement, les deux entrées E+ sont connectées en parallèle par un fil et non une piste.
Le filtre est conçu pour fonctionner avec une impédance de 4 000 $\Omega$ avec une inductance en parallèle. Sa fonction de transfert est illustrée en figure 19.

**Revendications**

1. Filtre à ondes acoustiques de surface à N pôles, N étant un nombre supérieur ou égal à 3, et comportant un ensemble de résonateurs, **caractérisé en ce que** :

   - les résonateurs sont couplés électriquement pour former un pont électrique à 4 bras ;
   - 2 bras comportant un premier et un troisième sous-ensembles identiques ($E_1$ et $E_3$) de $N_1$ résonateurs montés en parallèle ;
   - 2 bras comportant un deuxième et un quatrième sous-ensembles identiques ($E_2$ et $E_4$) de $N_2$ résonateurs montés en parallèle ;
   - avec $N_1 + N_2 = N$ ;
   - le produit de la capacité statique du premier sous-ensemble ($E_1$) par la capacité statique du troisième sous-ensemble ($E_3$) étant sensiblement équivalent au produit de la capacité statique du deuxième sous-ensemble ($E_2$) par la capacité statique du quatrième sous-ensemble ($E_4$), de manière à équilibrer le pont électrique.

2. Filtre à ondes acoustiques de surface selon la revendication 1, **caractérisé en ce que** N est pair et $N_1 = N_2 = N / 2$.

3. Filtre à ondes acoustiques de surface selon la revendication 1, **caractérisé en ce que** N est impair et $N_1 = (N -1) / 2$ et $N_2 = (N + 1) / 2$.

4. Filtre à ondes acoustiques de surface selon l'une des revendications 1 à 3, **caractérisé en ce qu'**au moins un bras comporte un unique dispositif à ondes de surface ayant une admittance équivalente à la mise en parallèle d'un sous-ensemble de résonateurs.

5. Filtre à ondes acoustiques de surface selon l'une des revendications 1 à 4, **caractérisé en ce qu'**au moins un bras comporte une structure équivalente à plusieurs résonateurs montés en parallèle, ladite structure comportant deux réseaux d'électrodes interdigitées constitutifs de la partie transduction des résonateurs, lesdits réseaux étant connectés à deux bus de polarités différentes et comprenant m voies acoustiques insérées entre les deux bus, la $i^{ème}$ voie acoustique possédant un pas $p_i$ d'électrodes, sur une longueur d'électrodes $w_i$ et $1 \le i \le m$.

**6.** Filtre à ondes acoustiques de surface selon la revendication 5, **caractérisé en ce que** la i$^{ème}$ voie acoustique comporte de chaque côté de la partie transduction deux réseaux réflecteurs.

**7.** Filtre à ondes acoustiques de surface selon l'une des revendications 5 ou 6, **caractérisé en ce que** les deux voies acoustiques consécutives sont reliées entre elles par des métallisations $m_i$, connectant les électrodes séparées d'un pas $p_i$ aux électrodes séparées d'un pas $p_{i+1}$.

**8.** Filtre à ondes acoustiques de surface selon l'une des revendications 5 à 7, **caractérisé en ce qu'**au moins un bras comprend une structure équivalente à deux résonateurs montés en parallèle et ladite structure comporte une voie acoustique supérieure et une voie acoustique inférieure de pas d'électrodes $p_1$ et de longueur d'électrodes $w_1$, une voie acoustique centrale de pas d'électrodes $p_2$ et de longueur d'électrodes $w_2$, les électrodes du réseau d'électrodes connecté au premier bus de la voie acoustique supérieure, étant alignées avec les électrodes du réseau d'électrodes connectés au second bus de la voie acoustique inférieure.

**9.** Filtres à ondes acoustiques de surface selon l'une des revendications 5 à 7, **caractérisé en ce que** pas les pas $p_1$ et $p_2$ sont égaux et **en ce que** la structure comprend deux voies acoustiques, les électrodes de chacun des réseaux d'électrodes étant décalées d'une distance $p_1$ entre les deux voies acoustiques.

**10.** Filtre à ondes acoustiques de surface selon l'une des revendications 1 à 3, **caractérisé en ce qu'**au moins un des bras comporte une structure équivalente à au moins deux résonateurs montés en parallèle, ladite structure comportant deux réseaux d'électrodes interdigitées, lesdits réseaux étant connectés à un premier et second bus de polarités différentes, de manière à définir un transducteur présentant un axe central (Z) parallèle aux électrodes, ledit transducteur comportant des électrodes positionnées symétriquement par rapport à l'axe central et reliées au premier bus et comportant des électrodes positionnées symétriquement par rapport à l'axe central et reliées au second bus de polarité opposée, de manière à exciter des modes longitudinaux symétriques et des modes longitudinaux antisymétriques.

**11.** Filtre à ondes acoustiques de surface selon la revendication 10, **caractérisé en ce que** le transducteur est inséré entre deux réseaux réflecteurs.

**12.** Filtre à ondes acoustiques de surface selon l'une des revendications 1 à 4. **caractérisé en ce qu'**au moins un des bras comprend un résonateur de type DART, avec des cellules transduction intercalées entre des cellules de réflexion.

**13.** Filtre à ondes acoustiques de surface selon la revendication 12, **caractérisé en ce que** le résonateur de type DART comprend des cavités résonantes.

**14.** Filtre à ondes acoustiques de surface selon l'une des revendications 12 ou 13, **caractérisé en ce que** le nombre de pôles est pair et **en ce que** la distance entre le centre de transduction d'une cellule de transduction et le centre de réflexion d'une cellule de réflexion adjacente à ladite cellule de transduction est de l'ordre de $(3 \pm d) \lambda/8 + k\lambda/2$ avec $\lambda$ longueur d'onde correspondant à la fréquence centrale du filtre, d inférieur à 1 et k entier.

**15.** Filtre à ondes acoustiques de surface **caractérisé en ce qu'**il comprend la mise en série de plusieurs ensembles de résonateurs, dont au moins un ensemble de résonateurs répond à l'une des revendications 1 à 14.

**Claims**

**1.** Surface-acoustic-wave filter with N poles, N being a number greater than or equal to 3, and comprising a set of resonators, **characterized in that**:

- the resonators are electrically coupled to form a 4-arm electrical bridge;
- 2 arms comprising a first and a third identical sub-assembly ($E_1$ and $E_3$) of $N_1$ parallel-connected resonators;
- 2 arms comprising a second and fourth identical sub-assembly ($E_2$ and $E_4$) of $N_2$ parallel-connected resonators;
- with $N_1 + N_2 = N$;
- the product of the static capacitance of the first sub-assembly ($E_1$) multiplied by the static capacitance of the third sub-assembly ($E_3$) being substantially equivalent to the product of the static capacitance of the second sub-assembly ($E_2$) multiplied by the static capacitance of the fourth sub-assembly ($E_4$), so as to balance the electrical bridge.

2. Surface-acoustic-wave filter according to Claim 1, **characterized in that** N is an even number and $N_1 = N_2 = N/2$.

3. Surface-acoustic-wave filter according to Claim 1, **characterized in that** N is an odd number and $N_1 = (N-1)/2$ and $N_2 = (N + 1)/2$.

4. Surface-acoustic-wave filter according to one of the Claims 1 to 3, **characterized in that** at least one arm comprises a single surface wave device having an admittance equivalent to the parallel connection of a subassembly of resonators.

5. Surface-acoustic-wave filter according to one of the Claims 1 to 4, **characterized in that** at least one arm comprises a structure equivalent to several parallel-connected resonators, said structure comprising two arrays of interdigitated electrodes constituting the transduction part of the resonators, said arrays being connected to two buses with different polarities and comprising m acoustic channels inserted between the two buses, the $i^{th}$ acoustic channel possessing a pitch $p_i$ of electrodes over a length of electrodes $w_i$ and $1 \leq i \leq m$.

6. Surface-acoustic-wave filter according to Claim 5, **characterized in that** the $i^{th}$ acoustic channel comprises two reflective arrays on each side of the transduction part.

7. Surface-acoustic-wave filter according to one of the Claims 5 or 6, **characterized in that** the two consecutive acoustic channels are connected to each other by metallizations $m_i$, connecting the electrodes separated by a pitch $p_i$ to the electrodes separated by a pitch $p_{i+1}$.

8. Surface-acoustic-wave filter according to one of the Claims 5 to 7, **characterized in** at least one arm comprises a structure equivalent to two parallel-connected resonators and said structure comprises an upper acoustic channel and a lower acoustic channel with an electrode pitch $p_1$ and an electrode length $w_1$, a central acoustic channel with an electrode pitch $p_2$ and an electrode length $w_2$, the electrodes of the array of electrodes connected to the first bus of the upper acoustic channel being aligned with the electrodes of the array of electrodes connected to the second bus of the lower acoustic channel.

9. Surface-acoustic-wave filter according to one of the Claims 5 to 7, **characterized in that** the pitches $p_1$ and $p_2$ are equal and **in that** the structure comprises two acoustic channels, the electrodes of each of the arrays of electrodes being offset by a distance $p_1$ between the two acoustic channels.

10. Surface-acoustic-wave filter according to one of the Claims 1 to 3, **characterized in that** at least one of the arms comprises a structure equivalent to at least two parallel-connected resonators, said structure comprising two interdigitated electrode arrays, said arrays being connected to a first bus and a second bus with different polarities so as to define a transducer having a central axis (Z) parallel to the electrodes, said transducer comprising electrodes positioned symmetrically with respect to the central axis and connected to the first bus and comprising electrodes positioned symmetrically with respect to the central axis and connected to the second bus with opposite polarity, so as to excite symmetrical longitudinal modes and antisymmetrical longitudinal modes.

11. Surface-acoustic-wave filter according to Claim 10, **characterized in that** the transducer is inserted between two reflector arrays.

12. Surface-acoustic-wave filter according to one of the Claims 1 to 4, **characterized in that** at least one of the arms comprises a DART type resonator with transduction cells interposed between reflection cells.

13. Surface-acoustic-wave filter according to Claim 12, **characterized in that** the DART type resonator comprises resonant cavities.

14. Surface-acoustic-wave filter according to one of the Claims 12 or 13, **characterized in that** the number of poles is an even number and **in that** the distance between the transduction centre of a transduction cell and the reflection centre of a reflection cell adjacent to said transduction cell is of the order of $(3 \pm d)\lambda/8 + k\lambda/2$, with $\lambda$ being the wavelength corresponding to the centre frequency or the filter, d being smaller than 1 and k being an integer.

15. Surface-acoustic-wave filter **characterized in that** it comprises the series connection of several sets of resonators, of which at least one set of resonators complies with one of the Claims 1 to 14.

**Patentansprüche**

1. Oberflächenschallwellen-Filter mit N Polen, wobei N eine Zahl größer oder gleich 3 ist, das eine Gruppe von Resonatoren umfaßt, **dadurch gekennzeichnet, daß**:

   - die Resonatoren elektrisch verbunden sind, um eine elektrische Brücke mit vier Zweigen zu bilden;

   - wobei zwei Zweige eine erste und eine zweite völlig gleiche Untergruppe ($E_1$ und $E_3$) aus $N_1$ parallelgeschalteten Resonatoren umfassen;

   - wobei zwei Zweige eine zweite und eine vierte völlig gleiche Untergruppe ($E_2$ und $E_4$) aus $N_2$ parallelgeschalteten Resonatoren umfassen;

   - wobei $N_1 + N_2 = N$;

   - wobei das Produkt aus der statischen Kapazität der ersten Untergruppe ($E_1$) und der statischen Kapazität der dritten Untergruppe ($E_3$) zu dem Produkt aus der statischen Kapazität der zweiten Untergruppe ($E_2$) und der statischen Kapazität der vierten Untergruppe ($E_4$) im wesentlichen äquivalent ist, derart, daß die elektrische Brücke im Gleichgewicht ist.

2. Oberflächenschallwellen-Filter nach Anspruch 1, **dadurch gekennzeichnet, daß** N geradzahlig ist und $N_1 = N_2 = N/2$.

3. Oberflächenschallwellen-Filter nach Anspruch 1, **dadurch gekennzeichnet, daß** N ungeradzahlig ist und $N_1 = (N - 1)/2$ und $N_2 = (N + 1)/2$.

4. Oberflächenschallwellen-Filter nach einem der Ansprüche 1 bis 3, **dadurch gekennzeichnet, daß** wenigstens ein Zweig eine einzige Oberflächenwellen-Vorrichtung enthält, die eine Admittanz besitzt, die zur Parallelschaltung einer Untergruppe aus Resonatoren äquivalent ist.

5. Oberflächenschallwellen-Filter nach einem der Ansprüche 1 bis 4, **dadurch gekennzeichnet, daß** wenigstens ein Zweig eine Struktur aufweist, die zu mehreren parallelgeschalteten Resonatoren äquivalent ist, wobei die Struktur zwei Gitter aus interdigitalen Elektroden, die für den Transduktionsteil der Resonatoren konstitutiv sind, enthält, wobei die Gitter mit zwei Bussen unterschiedlicher Polarität verbunden sind und m Schallwege aufweisen, die zwischen die beiden Busse eingefügt sind, wobei der i-te Schallweg auf einer Elektrodenlänge $w_i$ mit $1 \leq i \leq m$ eine Schrittweite $p_i$ der Elektroden aufweist.

6. Oberflächenschallwellen-Filter nach Anspruch 5, **dadurch gekennzeichnet, daß** der i-te Schallweg beiderseits des Transduktionsteils zwei Reflektor-Gitter umfaßt.

7. Oberflächenschallwellen-Filter nach einem der Ansprüche 5 oder 6, **dadurch gekennzeichnet, daß** die beiden aufeinanderfolgenden Schallwege miteinander über Metallisierungen $m_i$ verbunden sind, die die durch eine Schrittweite $p_i$ getrennten Elektroden mit den durch eine Schrittweite $p_{i+1}$ getrennten Elektroden verbinden.

8. Oberflächenschallwellen-Filter nach einem der Ansprüche 5 bis 7, **dadurch gekennzeichnet, daß** wenigstens ein Zweig eine Struktur aufweist, die zu zwei parallelgeschalteten Resonatoren äquivalent ist, und die Struktur einen oberen Schallweg und einen unteren Schallweg mit einer Elektrodenschrittweite $p_1$ und einer Elektrodenlänge $w_1$ sowie einen mittleren Schallweg mit einer Elektrodenschrittweite $p_2$ und einer Elektrodenlänge $w_2$ aufweist, wobei die Elektroden des Elektrodengitters, das an den ersten Bus des oberen Schallweges angeschlossen ist, auf die Elektroden des Elektrodengitters, das an den zweiten Bus des unteren Schallweges angeschlossen ist, ausgerichtet sind.

9. Oberflächenschallwellen-Filter nach einem der Ansprüche 5 bis 7, **dadurch gekennzeichnet, daß** die Schrittweiten $p_1$ und $p_2$ gleich sind und daß die Struktur zwei Schallwege umfaßt, wobei die Elektroden jedes Elektrodengitters um eine Strecke $p_1$ zwischen den beiden Schallwegen versetzt sind.

**10.** Oberflächenschallwellen-Filter nach einem der Ansprüche 1 bis, 3, **dadurch gekennzeichnet, daß** wenigstens einer der Zweige eine Struktur aufweist, die zu wenigstens zwei parallelgeschalteten Resonatoren äquivalent ist. wobei die Struktur zwei Gitter aus interdigitalen Elektroden enthält, wobei die Gitter an einen ersten und an einen zweiten Bus unterschiedlicher Polarität angeschlossen sind, derart, daß ein Meßwandler definiert wird, der eine zu den Elektroden parallele Mittelachse (Z) aufweist, wobei der Meßwandler Elektroden umfaßt, die in bezug auf die Mittelachse symmetrisch angeordnet und an den ersten Bus angeschlossen sind, und Elektroden aufweist, die in bezug auf die Mittelachse symmetrisch angeordnet und an den zweiten Bus mit entgegengesetzter Polarität angeschlossen sind, derart, daß symmetrische longitudinale Schwingungen und antisymmetrische longitudinale Schwingungen angeregt werden.

**11.** Oberflächenschallwellen-Filter nach Anspruch 10, **dadurch gekennzeichnet, daß** der Meßwandler zwischen zwei Reflektor-Gitter eingefügt ist.

**12.** Oberflächenschallwellen-Filter nach einem der Ansprüche 1 bis 4, **dadurch gekennzeichnet, daß** wenigstens einer der Zweige einen Resonator des DART-Typs umfaßt, wobei zwischen die Reflexionszellen Transduktionszellen verschachtelt eingefügt sind.

**13.** Oberflächenschallwellen-Filter nach Anspruch 12, **dadurch gekennzeichnet, daß** der Resonator des DART-Typs Resonanzhohlräume aufweist.

**14.** Oberflächenschallwellen-Filter nach einem der Ansprüche 12 oder 13, **dadurch gekennzeichnet, daß** die Anzahl der Pole geradzahlig ist und daß der Abstand zwischen der Transduktionsmitte einer Transduktionszelle und der Reflexionsmitte einer Reflexionszelle, die an die Transduktionszelle angrenzt, in der Größenordnung von $(3 \pm d)$ $\lambda/8 + k\lambda/2$ liegt, wobei $\lambda$ die der Mittenfrequenz des Filters entsprechende Wellenlänge ist, d kleiner als 1 ist und k ganzzahlig ist.

**15.** Oberflächenschallwellen-Filter, **dadurch gekennzeichnet, daß** es die Reihenschaltung mehrerer Gruppen aus Resonatoren umfaßt, wovon wenigstens eine Gruppe einem der Ansprüche 1 bis 14 entspricht.

FIG.1

FIG.2

FIG.3

FIG.4

FIG.5a

FIG.5b

FIG.6

FIG.7

CHANGEMENT
DE SIGNE DE L'EXCITATION

## FIG.8

DISTANCE RÉFLEXION TRANSDUCTION = 3λ/8

## FIG.9

DISTANCE CENTRE DE TRANSDUCTION-CENTRE DE REFLEXION=(3/8+d)λ

## FIG.10

DISTANCE CENTRE DE TRANSDUCTION-CENTRE DE RÉFLEXION=(3/8+d)λ

## FIG.11

FIG.12

FIG.13

FIG.14

FIG.15

FIG.16

FIG.17

FIG.18

FIG.19